# EUROPEAN PATENT APPLICATION

(11) **EP 4 607 791 A1**
(43) Date of publication of application: **27.08.2025**
(21) Application number: 24781318.1
(22) Date of filing: 29.03.2024
(51) Int. Cl.: H02S 50/00, G01R 21/133, H04B 17/309

(54) **INVERTER AND MAIN CONTROLLER OF PHOTOVOLTAIC SYSTEM, AND OPERATING METHOD OF SOLAR SYSTEM**

(30) Priority: 29.03.2023 KR 20230041524
(71) Applicant: Hanwha Solutions Corporation, Jung-gu Seoul 04541 (KR)
(72) Inventor: KIM, Hyun Gon, Seoul 04541 (KR); NOH, Hong Il, Seoul 04541 (KR); YUN, Ju Hwan, Seoul 04541 (KR)
(74) Representative: Mooser, Sebastian Thomas
(86) International application number: PCT/KR2024/004094
(87) International publication number: WO 2024/205328

(57) **Abstract**

The present disclosure provides a photovoltaic power generation system including a photovoltaic panel, a module-level power electronics (MLPE) configured to sequentially store N pieces of data, each obtained by accumulating a power generation amount of the photovoltaic panel, in a first buffer at every first set time, wherein N is a natural number greater than or equal to 2, and a primary controller configured to request the N pieces of data from the MLPE at every second set time, receive the N pieces of data from the MLPE, and store the received data in a second buffer, wherein the primary controller is configured to compare a second data set of N pieces of data. which are previously stored in a second buffer, with a first data set of N pieces of data currently received from the MLPE and update the second data set of N pieces of data.

## Description

### Technical Field

The present disclosure relates to an inverter and a primary controller of a photovoltaic power generation system, and to a photovoltaic power generation method.

### Background Art

In general, a photovoltaic power generation system is a system that converts solar energy into electrical energy using photovoltaic cells and transmits the electrical energy to a commercial power grid, and this process does not cause environmental pollution and enables the photovoltaic power generation system to be used semi-permanently.

Such a photovoltaic power generation system includes a plurality of photovoltaic panels, a plurality of module-level power electronics (MLPEs), a primary controller, and a server.

The plurality of photovoltaic panels may be connected in at least one of a series connection and a parallel connection, and each of the plurality of MLPEs is provided for each of the plurality of photovoltaic panels.

Here, the MLPEs are provided for the plurality of photovoltaic panels, optimize the power efficiency of the photovoltaic panels, and transmit power generation information, including power generation amount, temperature, and failure information of the photovoltaic panels, to the primary controller or an inverter including the primary controller.

The primary controller controls the plurality of MLPEs, collects the power generation information received from the plurality of MLPEs, and transmits the collected information to the server.

The server monitors power generation states of the plurality of photovoltaic panels using the power generation information of the plurality of photovoltaic panels.

Meanwhile, cumulative power generation amount data is required to quantitatively check a power generation amount of the photovoltaic panel.

To this end, the MLPE sequentially stores the cumulative power generation amount data of the photovoltaic panel in a buffer at preset time intervals and periodically transmits the data stored in the buffer to the primary controller in response to a request from the primary controller.

Here, when a communication failure occurs between the MLPE and the primary controller and communication is not performed for a certain period of time, the primary controller may fail to receive a portion of the data. Further, the same data may be redundantly transmitted to the primary controller due to a system failure. In this case, a problem arises in that reliability of the data is reduced. Further, the reliability of the data may vary depending on a communication environment, which causes a problem in that the cumulative power generation amount of the photovoltaic panel cannot be accurately monitored.

### Disclosure

### Technical Problem

In order to solve the above-described problems of the related art, an object of the present disclosure is to prevent data from being lost even when a communication failure occurs and communication is not performed for a certain period of time, and to prevent duplicated data from being stored due to a system failure.

The technical problems to be solved by the present disclosure are not limited to the problems mentioned above, and any other technical problems not mentioned herein will be clearly understood from the following description by those skilled in the art to which the present disclosure pertains.

### Technical Solution

According to an embodiment of the present disclosure there is provided a method of operating a photovoltaic power generation system, the method including generating power generation amount data obtained by accumulating a power generation amount of a photovoltaic panel at every first set time, sequentially storing the power generation amount data in a first buffer, obtaining N pieces of the power generation amount data stored in the first buffer as a first data set at every second set time, wherein N is a natural number greater than or equal to 2, comparing a second data set, which is a set of M pieces of data previously stored in a second buffer, with the first data set that is most recently obtained, wherein M is a natural number greater than or equal to 2, and in response to the comparing, updating the second buffer based on the first data set.

In the present disclosure, the comparing may include searching for, in a reverse order of the storage order of the second buffer (hereinafter referred to as a reverse order), whether latest non-zero data (hereinafter referred to as second buffer latest data) is present in the second data set, and searching for, in a storage order of the first buffer, whether the second buffer latest data is present in the first data set, when the second buffer latest data is present.

In the present disclosure, in the updating, when the second buffer latest data is present in the first data set, at least one piece of new data, which is stored after the second buffer latest data, may be stored in the second buffer.

In the present disclosure, in the updating, when a number of the at least one piece of new data, which is stored after the second buffer latest data, in the first data set is Nnew, Nnew pieces of the data may be sequentially stored in (M-Nnew+1)th to Mth spaces among storage spaces of the second buffer.

In the present disclosure, in the updating, pieces of data previously stored in first to (M-Nnew)th buffer spaces of the second buffer may be deleted, and pieces of data stored in the (M-Nnew+1)th to Mth buffer spaces may be newly stored in first to (M-Nnew)th spaces.

In the present disclosure, in the updating, when the second buffer latest data is not present in the first data set, the first data set may be entirely stored in the second buffer.

In the present disclosure, in the updating, the first data set may be entirely stored sequentially in (M-N+1)th to Mth buffer spaces of the second buffer.

In the present disclosure, in the updating, when the second buffer latest data is not present in the second data set, the first data set may be entirely stored in the second buffer.

In the present disclosure, the in the updating, the first data set may be entirely stored sequentially in (M-N+1)th to Mth buffer spaces of the second buffer.

In the present disclosure, the first buffer may have a size configured to store up to the N pieces of the power generation amount data, and the second buffer may have a size configured to store up to the M pieces of the power generation amount data, wherein N may be a number less than or equal to M.

According to an embodiment of the present disclosure, there is provided a primary controller of a photovoltaic power generation system, wherein the primary controller is configured to request to a module-level power electronics (MLPE) of the photovoltaic power generation system for a first data set stored in a first buffer of the MLPE, obtain the first data set from the MLPE, compare a second data set, which is a set of M pieces of data (where M is a natural number greater than or equal to 2) previously stored in a second buffer of the primary controller, with the first data set that is most recently received from the MLPE, and in response to the comparing, update the second buffer based on the first data set.

In the present disclosure, the first data set may be a set of N pieces of data (where N is a natural number greater than or equal to 2), each obtained by accumulating a power generation amount of a photovoltaic panel at every first set time, and the primary controller may be further configured to request the first data set from the MLPE at every second set time.

In the present disclosure, the primary controller may be further configured to search for, in a reverse order of the storage order (hereinafter referred to as a reverse order) of the second buffer, whether latest non-zero data (hereinafter referred to as second buffer latest data) is present in the second data, search for, in a storage order of the first buffer, whether the second buffer latest data is present in the first data set based on the presence of the second buffer latest data, and store at least one piece of new data, which is stored after the second buffer latest data, in the second buffer based on the presence of the second buffer latest data in the first data set.

In the present disclosure, the primary controller may be further configured to search for, in a reverse order, whether second buffer latest data is present in the second data set, and based on absence of the latest data in the second buffer, entirely store the first data set in the second buffer.

In the present disclosure, the primary controller may be further configured to search for, in a reverse order, whether second buffer latest data is present in the second data set, search for, in a storage order of the first buffer, whether the second buffer latest data is present in the first data set based on the presence of the second buffer latest data, and entirely store the first data set of N pieces of data in the second buffer based on absence of the second buffer data in the first data set.

In the present disclosure, the first buffer may have a size configured to store up to N pieces of power generation amount data, and the second buffer may have a size configured to store up to M pieces of power generation amount data, wherein N may be a number less than or equal to M.

In the present disclosure, the MLPE may be configured to sequentially delete the power generation amount data, in a storage order of the first buffer, after the N pieces of power generation amount data are stored in the first buffer, and sequentially store new data.

In the present disclosure, the primary controller may be further configured to, after the second data set including M pieces of power generation amount data is stored in the second buffer, sequentially delete the power generation amount data in a storage order of the second buffer, and sequentially store new data.

According to an embodiment of the present disclosure, there is provided an inverter including a primary controller of a photovoltaic power generation system, wherein the inverter is configured to request to a module-level power electronics (MLPE) of the photovoltaic power generation system for a first data set stored in a first buffer of the MLPE, obtain the first data set from the MLPE, compare a second data set, which is a set of M pieces of data (where M is a natural number greater than or equal to 2) previously stored in a second buffer of the primary controller, with the first data set that is most recently received from the MLPE, and in response to the comparing, update the second buffer based on the first data set.

In the present disclosure, the first data set may be a set of N pieces of data (where N is a natural number greater than or equal to 2), each obtained by accumulating a power generation amount of a photovoltaic panel at every first set time, and the primary controller may be configured to request the first data set from the MLPE at every second set time.

### Advantageous Effects

According to the present disclosure, data loss can be prevented even when a communication failure occurs between module-level power electronics (MLPE) and a primary controller and communication is not performed for a certain period of time, and duplicated data can be prevented from being stored due to a system failure. As a result, reliability of the data can be improved, thereby enabling accurate monitoring of a cumulative power generation amount of a photovoltaic panel.

The effects to be obtained from the present disclosure are not limited to those mentioned above, and any other effects not mentioned herein will be clearly understood from the following description by those skilled in the art to which the present disclosure pertains.

### Description of Drawings

FIGS. 1A and 1B are diagrams illustrating a photovoltaic power generation system according to an embodiment of the present disclosure.
FIG. 2 is a detailed block diagram of module-level power electronics (MLPE) and a primary controller according to an embodiment of the present disclosure.
FIG. 3 is a flowchart illustrating a method of operating the photovoltaic power generation system according to an embodiment of the present disclosure.
FIG. 4 illustrates a method in which the MLPE stores data in a first buffer according to an embodiment of the present disclosure.
FIGS. 5A and 5B illustrate examples of updating a second buffer according to an embodiment of the present disclosure.
FIGS. 6A and 6B illustrate examples of updating the second buffer according to another embodiment of the present disclosure.
FIG. 7 illustrates examples of updating the second buffer according to another embodiment of the present disclosure.
FIG. 8 is a flowchart illustrating a method of updating cumulative power generation amount data of the MLPE according to an embodiment of the present disclosure.
FIG. 9 is a detailed flowchart illustrating a method of updating cumulative power generation amount data of the MLPE according to an embodiment of the present disclosure.

### Best Mode

The terms used in the embodiments have been selected from general terms that are currently widely used when possible but may vary according to an intention of those of ordinary skill in the art, precedents, or the emergence of new technologies. In addition, the applicant may arbitrarily select terms in a particular case, and in this case, the meaning of the terms will be described in detail in the corresponding part. Accordingly, the terms used herein should be defined on the basis of the meaning of the terms and the content throughout the specification, instead of the names of the terms.

Throughout the specification, when a part is referred to "include" a certain component, it means that it may further include other components rather than exclude other components, unless specifically indicates otherwise.

In addition, terms including ordinal numbers such as "first" or "second" used herein may be used to describe various components, but the components are not limited by the terms, and the terms are used only for the purpose of distinguishing one component from another. The terms may only be used to distinguish one component from another.

Hereinafter, embodiments will be described in detail with reference to the accompanying drawings. However, the embodiments may be implemented in several different forms and are not limited to embodiments that will be described below.

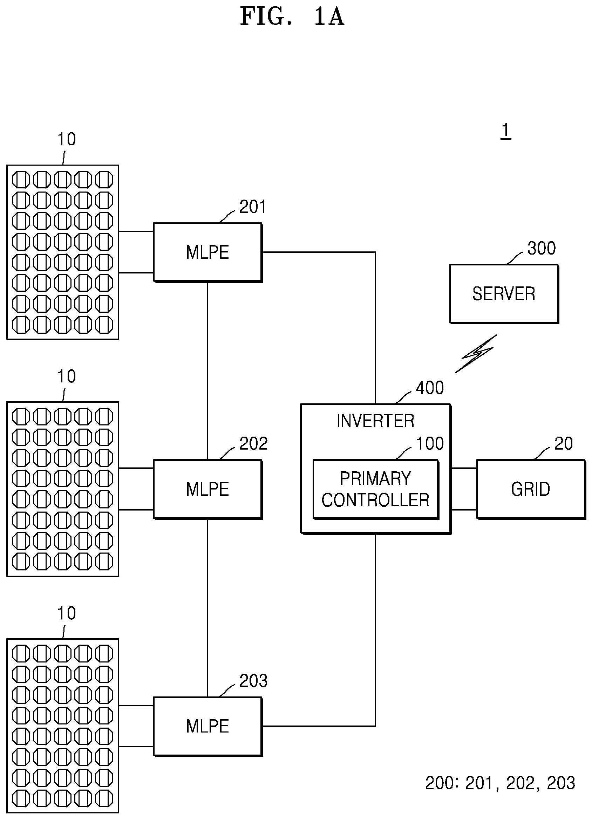

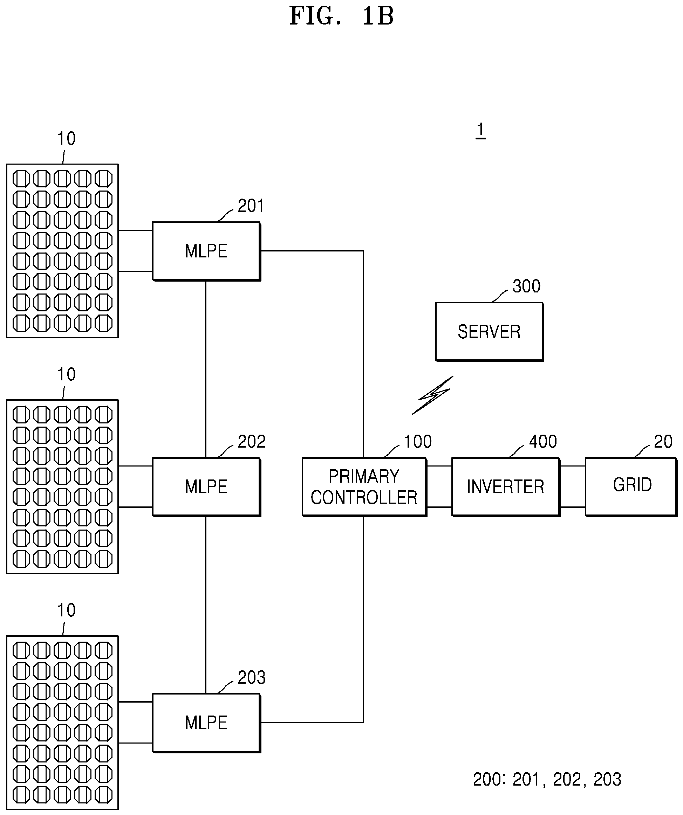

FIGS. 1A and 1B are diagrams illustrating a photovoltaic power generation system according to an embodiment of the present disclosure.

As illustrated in FIG. 1A, the photovoltaic power generation system according to an embodiment of the present disclosure may include a plurality of photovoltaic panels 10, an inverter 400 including a primary controller 100, a plurality of module-level power electronics (MLPEs) 200, and a server 300. Alternatively, as illustrated in FIG. 1B, a photovoltaic power generation system according to another embodiment of the present disclosure may include the plurality of photovoltaic panels 10, the primary controller 100, the plurality of MLPEs 200, the inverter 400, and the server 300.

That is, as shown in FIG. 1A, the photovoltaic power generation system according to an embodiment may be configured such that the inverter 400 includes the primary controller 100, and alternatively, according to another embodiment, as shown in FIG. 1B, the photovoltaic power generation system may be configured such that the inverter 400 is included between the primary controller 100 and a grid 20. Here, the inverter 400 may convert direct current (DC) power generated by the plurality of photovoltaic panels 10 into alternating current (AC) power and transmit the converted AC power to the grid 20. Hereinafter, for convenience of description, an embodiment in which the primary controller 100 is included in the inverter 400, as shown in FIG. 1A, will be described as an example. Further, in the following description, the plurality of photovoltaic panels 10 and the plurality of MLPEs 200 will be collectively described, but, the photovoltaic panels 10 and the MLPEs 200 may be separate from each other and may be configured as different types or models.

According to an embodiment, each of the plurality of photovoltaic panels 10 may refer to a photovoltaic power generation panel in a module unit. Further, the plurality of photovoltaic panels 10 may be connected in at least one of a series connection and a parallel connection, and each of the plurality of MLPEs 200 may be provided for each of the plurality of photovoltaic panels 10. Further, one MLPE 200 may be connected to one photovoltaic panel 10, or one MLPE 200 may also be connected to the plurality of photovoltaic panels 10. The MLPE 200 may transmit power generation information, including power generation amount, temperature, and failure information of the photovoltaic panel 10, to the primary controller 100, and may receive an operation command from the primary controller 100 to optimize power efficiency.

Here, information transmission and reception between the plurality of MLPEs 200 and the primary controller 100 may be performed by a power line communication (PLC) method.

The primary controller 100 may collect the power generation information received from the plurality of MLPEs 200 and transmit the collected information to the server 300, and the server 300 may monitor power generation states of the plurality of photovoltaic panels 10 using the power generation information of the plurality of photovoltaic panels 10.

Here, the information transmission and reception between the primary controller 100 and the server 300 may be performed in a wired or wireless manner.

The primary controller 100 may control the plurality of MLPEs 200 according to the power generation states of the photovoltaic panels 10.

In order to monitor the power generation states of the plurality of photovoltaic panels 10, the primary controller 100 may transmit command data to the plurality of **MLPEs** 200, and the plurality of MLPEs 200 may transmit response data, including the power generation information of the photovoltaic panels 10, to the primary controller 100 in response to the command data. In addition, the primary controller 100 collects the power generation information of the plurality of photovoltaic panels 10 and transmits the collected information to the server 300.

Further, according to an embodiment of the present disclosure, the inverter 400 is a component mounted in a power conversion system (PCS) and configured to perform power conversion to supply power generated by the photovoltaic panels 10 to a load or a grid. As described above, as shown in FIG. 1A, the inverter 400 may include the primary controller 100, or as shown in FIG. 1B, the inverter 400 may be provided separately from the primary controller 100. In the following description, for convenience of description, an embodiment in which the inverter 400 includes the primary controller 100, as shown in FIG. 1A, will be described as a reference, and an operation of the inverter 400 may be understood as an operation of the primary controller 100.

Meanwhile, cumulative power generation amount data is required to quantitatively check the power generation amount of the photovoltaic panel 10.

To this end, the MLPE 200 sequentially stores the cumulative power generation amount data of the photovoltaic panel 10 in a buffer at preset time intervals and periodically transmits the data stored in the buffer to the primary controller 100 in response to a request from the primary controller 100.

Here, when a communication failure occurs between the MLPE 200 and the primary controller 100 and communication is not performed for a certain period of time, the primary controller 100 may fail to receive a portion of the data. Further, the same data may be redundantly transmitted to the primary controller 100 due to a system failure. In this case, a problem arises in that reliability of the data is reduced. Further, the reliability of the data may vary depending on a communication environment, which may result in an inability to accurately monitor the cumulative power generation amount of the photovoltaic panel 10.

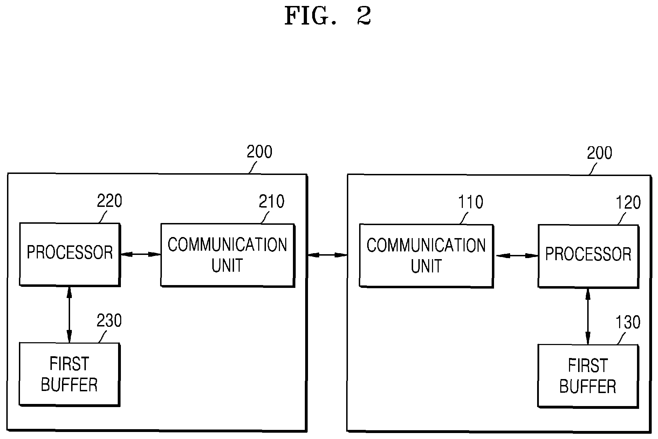

FIG. 2 is a detailed block diagram of the MLPE and the primary controller according to an embodiment of the present disclosure.

Referring to FIG. 2, the MLPE 200 may include a communication unit 210, a processor 220, and a first buffer 230, and the primary controller 100 may include a communication unit 110, a processor 120, and a second buffer 130. Here, the primary controller 100 may be implemented as a device configured to update the cumulative power generation amount data of the MLPE 200.

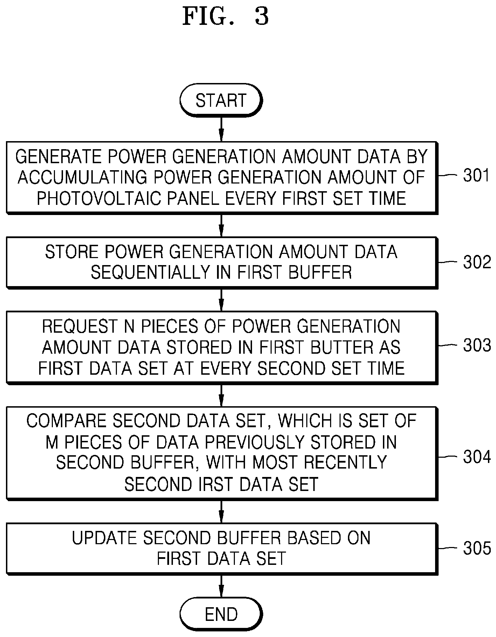

FIG. 3 is a flowchart illustrating a method of operating the photovoltaic power generation system according to an embodiment of the present disclosure.

Referring to FIGS. 2 and 3 together, the MLPE 200 generates power generation amount data by accumulating a power generation amount of the photovoltaic panel at every first set time (301).

Further, the MLPE 200 sequentially stores the power generation amount data in the first buffer (302).

Further, the primary controller 100 obtains N pieces of power generation amount data stored in the first buffer as a first data set at each second set time (303).

Further, the primary controller 100 compares a second data set, which is a set of M pieces of data previously stored in the second buffer, with the most recently obtained first data set (304).

Further, the primary controller 100 updates the second buffer based on the first data set (305).

Hereinafter, the primary controller and the inverter of the photovoltaic power generation system, and the method of operating the photovoltaic power generation system according to the embodiment described with reference to FIGS. 2 and 3 will be described in more detail.

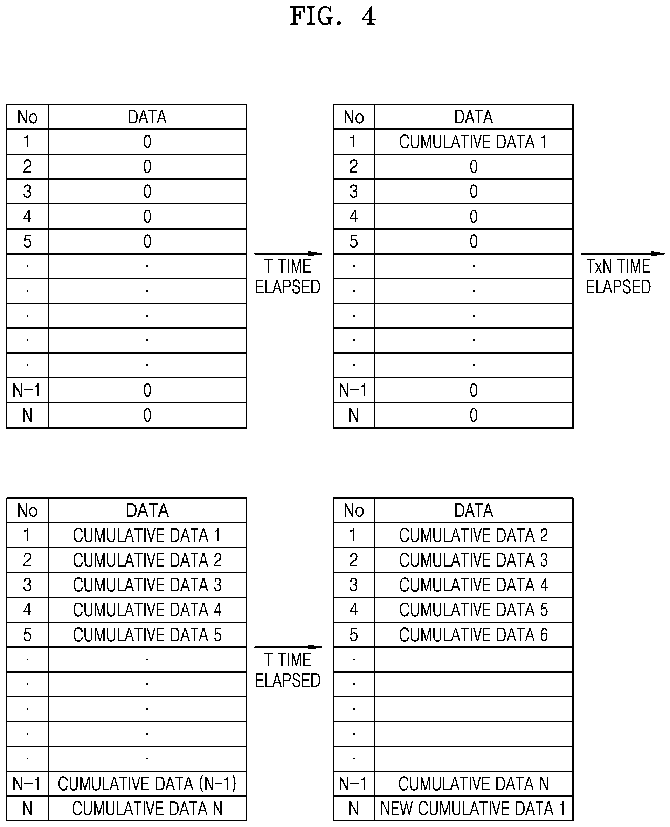

FIG. 4 illustrates a method in which the MLPE stores data in the first buffer according to an embodiment of the present disclosure.

Referring to FIG. 4, the processor 220 of the MLPE 200 sequentially stores N (where N is a natural number greater than or equal to 2) pieces of power generation amount data, each obtained by accumulating a power generation amount of the photovoltaic panel 10 at every first set time T, in the first buffer 230.

Here, the first buffer 230 has a size capable of storing up to N pieces of power generation amount data.

Specifically, the first buffer 230 is configured with first to Nth buffer spaces, and data may be stored in each buffer space. Further, the N pieces of data are sequentially stored from the first buffer space to the Nth buffer space according to the order in which the data is input.

For example, at the initial operation of the MLPE 200, no data is stored in each buffer space of the first buffer 230, and thereafter, when the MLPE 200 operates and the first set time T elapses, data 1, which is obtained by accumulating a power generation amount of the photovoltaic panel 10 during the first set time T, is stored in the first buffer space. The above process is repeated until data N is stored in the first buffer 230. Accordingly, data 1 to data N are sequentially stored in the first to Nth buffer spaces of the first buffer 230.

Here, a storage cycle of the N pieces of data may be defined as a product of the first set time T and a size N of the first buffer 230.

The N pieces of data are stored in the first buffer 230 from a point in time at which the N pieces of data are stored in the first buffer 230 until the storage cycle elapses and before the first set time T elapses again, and are then deleted from the first buffer 230. That is, after the N pieces of data are stored in the first buffer 230, the N pieces of data are sequentially deleted from the first buffer 230 in the order in which the N pieces of data were stored.

Specifically, referring to FIG. 3, after data 1 to data N are sequentially stored in the first to Nth buffer spaces of the first buffer 230, when the first set time T elapses, new data 1 needs to be stored in the first buffer 230, but, since the first buffer 230 can store only up to N pieces of data, the previously stored data 1, which was stored first among the N pieces of data, is deleted, and the new data is stored. This process is repeated whenever new data is stored.

Here, data 1 may be deleted by overwriting data 1 to data (N-1), which were stored from the first buffer space to the (N-1)th buffer space, respectively with data 2 to data N, which were stored from the second buffer space to the Nth buffer space.

In addition, new data may be stored in the Nth buffer space by overwriting data N stored in the Nth buffer space with the new data.

Accordingly, data is sequentially stored in the first to Nth buffer spaces of the first buffer 230.

The processor 120 of the primary controller 100 requests N pieces of power generation amount data as a first set from the processor 220 of the MLPE 200 at each second set time. Here, the communication unit 110 of the primary controller 100 may transmit command data for requesting the first data set to the communication unit 210 of the MLPE 200. In addition, the second set time may be shorter than a cycle (TxN) in which the above-described MLPE 200 stores N pieces of data.

The processor 220 of the MLPE 200 sequentially stores N pieces of data, each obtained by accumulating a power generation amount of the photovoltaic panel 10, in the first buffer 230 at every first set time T, regardless of a data request from the primary controller 100.

The processor 220 of the MLPE 200 transmits the N pieces of power generation amount data, which are stored in the first buffer 230, as the first data set to the communication unit 110 of the primary controller 100 through the communication unit 210, in response to the data request.

The communication unit 110 of the primary controller 100 receives the first data set from the MLPE 200, and the processor 120 of the primary controller 100 selects new data based on the received first data set and stores the selected new data in the second buffer 130.

Such a process of requesting and receiving data is sequentially performed for each of the plurality of MLPEs 200.

The processor 120 of the primary controller 100 compares the second data set previously stored in the second buffer 130 with the first data set most recently received from the MLPE 200 and updates data in the second buffer. At this time, the first buffer has a size capable of storing up to N pieces of power generation amount data, and the second buffer has a size capable of storing up to M pieces of power generation amount data, wherein M may be greater than or equal to N.

Here, since the second set time, which is a cycle in which the primary controller 100 receives data from the MLPE 200, is shorter than the cycle (TxN) in which the MLPE 200 stores N pieces of data, the first data set may include data that overlaps with the second data set. That is, the first data set may include both data previously stored in the second buffer 130 and new data.

Accordingly, the processor 120 of the primary controller 100 determines whether the latest data, which is most recently stored in the second data set, is included in the first data set. Here, when the latest data is present in the first data set, the processor 120 stores new data, which is stored after the latest data, in the second buffer 130.

Specifically, the processor 120 may search for the latest non-zero data (hereinafter referred to as 'second buffer latest data') in the second data set in a reverse order of the storage order of the second buffer 130, may search for the latest data in the first data set in a storage order in the first buffer 230 based on the presence of the second buffer latest data, and may store at least one piece of new data, which is stored after the latest data, in the second buffer 130 based on the presence of the latest data in the first buffer 230.

That is, the processor 120 searches, in the reverse order, for the second buffer latest data in the second buffer, and when the second buffer latest data is present in the second data set, the processor 120 searches, in the storage order, for the second buffer latest data in the first data set. When the second buffer latest data is present in the first data set, at least one piece of new data, which is stored after the second buffer latest data, may be stored in the second buffer.

When the second buffer latest data is not present in the first data set, the processor 120 stores the entire first data set in the second buffer. Alternatively, when the second buffer latest data is not present in the second data set, the entire first data set may be stored in the second buffer.

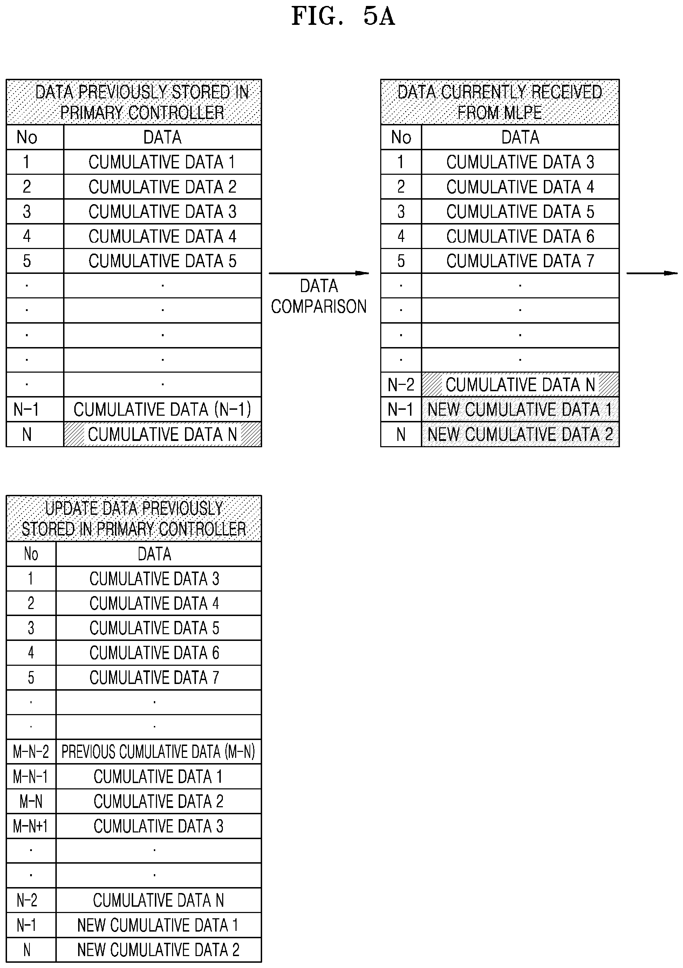

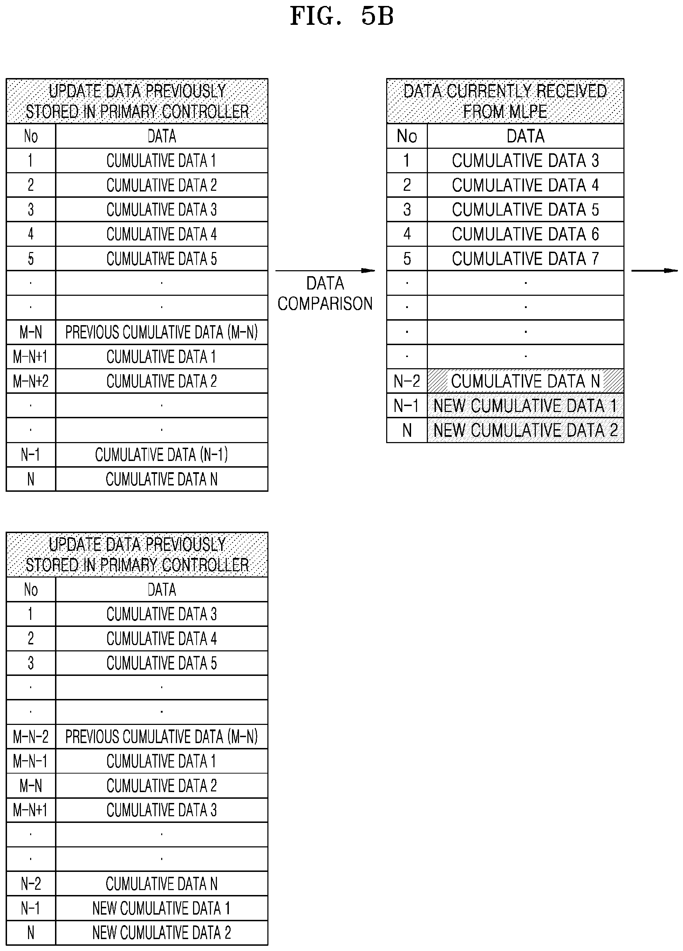

FIGS. 5A and 5B illustrate examples of updating the second buffer according to an embodiment of the present disclosure.

According to an embodiment of the present disclosure, FIG. 5A assumes a case in which N is equal to M (i.e., the number of buffer spaces in the second buffer is the same as the number of buffer spaces in the first buffer), and FIG. 5B assumes a case in which M is greater than N (i.e., the number of buffer spaces in the second buffer is greater than the number of buffer spaces in the first buffer).

For example, referring to FIG. 5A, the second buffer 130 of the primary controller 100 sequentially stores from data 1 to data N as a second data set of N pieces of data. In addition, the primary controller 100 receives, from the MLPE 200, data 3 to data N, new data 1, and new data 2 as a first data set of N pieces of data.

Here, since the first data set includes data N, the first data set may be regarded as having been received within the cycle (TxN) in which the MLPE 200 stores N pieces of data from the point in time at which the second data set is received.

The processor 120 of the primary controller 100 determines whether the latest non-zero data (hereinafter referred to as "second buffer latest data") is present in the second data set, in a reverse order of the storage order of the second buffer 130. Here, when cumulative data N, which is the latest data, is present in the second data set, the processor 120 searches, in a storage order, for cumulative data N in the first data set stored in the first buffer 230. Here, when cumulative data N is present in the first buffer 230, new data 1 and new data 2, which are stored after the cumulative data N in the first data set of N pieces of data, are stored in the second buffer 130.

The second buffer 130 of the primary controller 100 may have a size capable of storing up to N pieces of data, but is not limited thereto, and may have a larger size. The second buffer 130 may be provided in a quantity corresponding to the number of MLPEs 200.

Specifically, the second buffer 130 is configured with first to Nth buffer spaces, and individual power generation amount data may be stored in each buffer space. In addition, the first data set of N pieces of data is sequentially stored from the first buffer space to the Nth buffer space according to the order in which the data is input.

The first data set is sequentially deleted from the second buffer 130 according to the storage order of the first data set of N pieces of data after being stored in the second buffer 130.

For example, referring to FIG. 4, when data 1 to data N are received as a first data set from the MLPE 200, the second buffer 130 sequentially stores data 1 to data N in the first to Nth buffer spaces.

In addition, new data 1 and new data 2, which are stored after data N in the first data set, need to be stored in the second buffer 130, but, since the second buffer 130 can store only up to N pieces of data, data 1 and data 2, which were stored first among the previously stored N pieces of data, are deleted, and the new data 1 and new data 2 are stored instead. This process is repeated whenever new data is stored.

Here, cumulative data 1 and cumulative data 2 may be deleted by overwriting data 3 to data N, which were stored in the third to Nth buffer spaces, onto data 1 to data (N-2), which were stored in the first to (N-2)th buffer spaces, respectively.

In addition, new data 1 and new data 2 may be stored in the (N-1)th buffer space and the Nth buffer space by respectively overwriting data N-1 and data N stored in the (N-1)th buffer space and the Nth buffer space.

Accordingly, the power generation amount data in the first data set is sequentially stored in the first to Nth buffer spaces of the second buffer 130.

FIG. 5B assumes the case in which M is greater than N (i.e., the number of buffer spaces of the second buffer is greater than the number of buffer spaces of the first buffer), as described above. Unlike FIG. 5A, in the embodiment of FIG. 5B, previous cumulative data 1 to cumulative data (M-N) may be previously stored in first to (M-N)th buffer spaces of the second buffer, and cumulative data 1 to cumulative data N may be stored in (M-N+1)th to Mth buffer spaces.

In this case, as in FIG. 5A, when the first data set including new data 1 and new data 2 is obtained, previous cumulative data 3 to cumulative data (M-N) are stored in the first to (M-N-2)th buffer spaces, cumulative data 1 to cumulative data N are stored in (M-N-1)th to (M-2)th buffer spaces, and new cumulative data 1 and new cumulative data 2 are respectively stored in (M-1)th and Mth buffer spaces.

That is, according to an embodiment, when at least one piece of new data, which is stored after the second buffer latest data, is present in the first data set and the number of at least one piece of new data is Nnew, the processor 120 may sequentially store the Nnew pieces of data in (M-Nnew+1)th to Mth spaces among the storage spaces of the second buffer. To this end, the processor 120 may delete previously stored data in first to (M-Nnew)th buffer spaces of the second buffer, and newly store the data previously stored in the (M-Nnew+1)th to Mth buffer spaces into the first to (M-Nnew)th spaces.

As described above, according to the present disclosure, even when a communication failure occurs between the MLPE 200 and the primary controller 100 and communication is not performed for a certain period of time, the primary controller 100 is able to prevent data from being lost without a separate communication integrity check, as long as the communication is performed at least once within the cycle (TxN) in which the MLPE 200 stores N pieces of data from a point in time at which the second data set of N pieces of data is received. In addition, duplicate data storage due to a system failure can be prevented. As a result, the reliability of the data can be improved, thereby enabling accurate monitoring of the cumulative power generation amount of the photovoltaic panel 10.

The processor 120 of the primary controller 100 may compare the latest data stored in the second buffer 130 with the first data set in the storage order of the first data set of N pieces of data.

When the latest data is not present in the first data set, the processor 120 of the primary controller 100 deletes the second data set of N pieces of data and stores the first data set of N pieces of data in the second buffer 130.

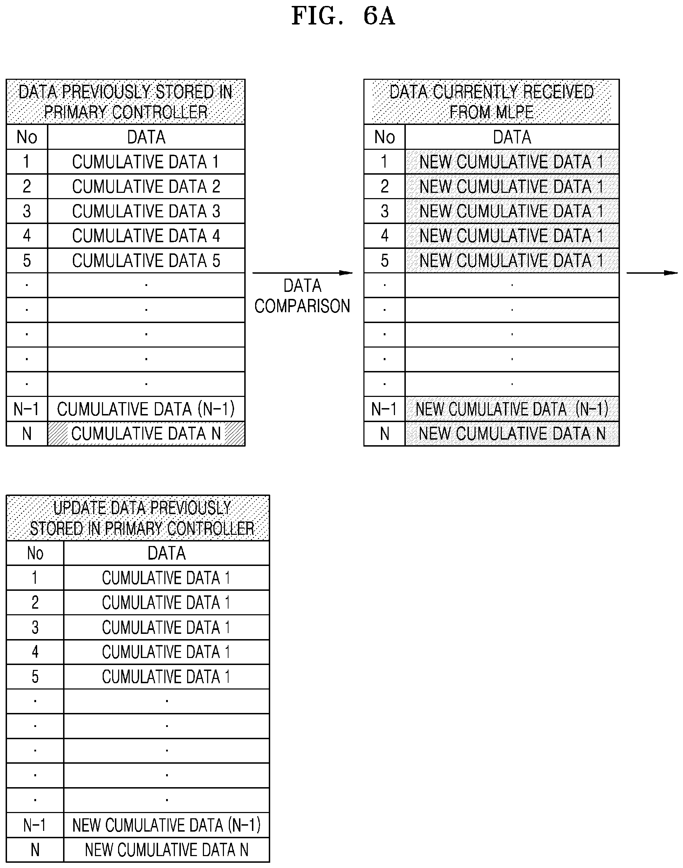

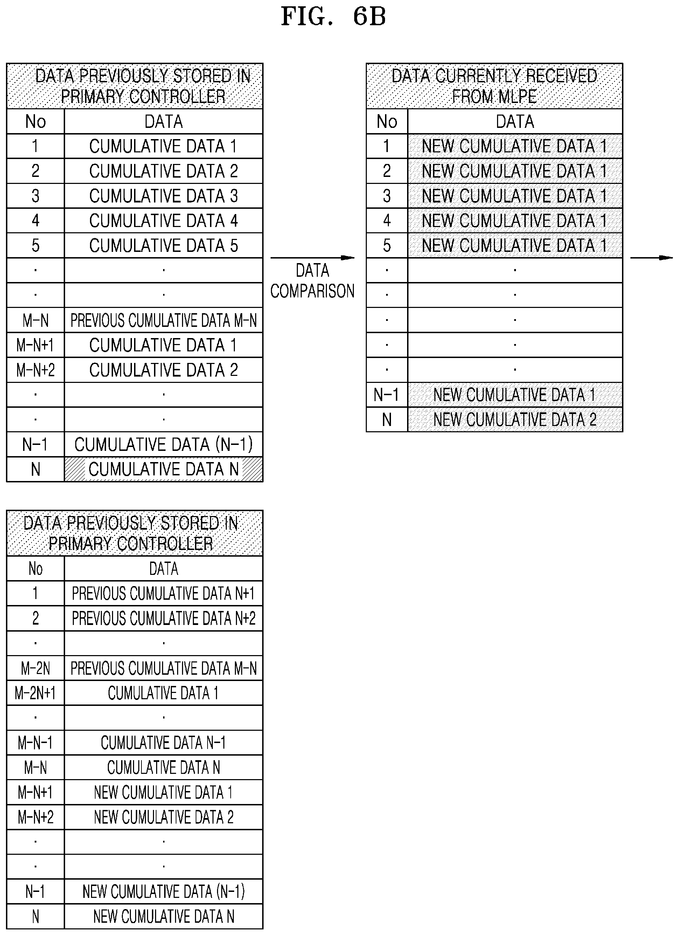

FIGS. 6A and 6B illustrate examples of updating the second buffer according to another embodiment of the present disclosure.

According to an embodiment of the present disclosure, FIG. 6A assumes a case in which N is equal to M (i.e., the number of buffer spaces in the second buffer is the same as the number of buffer spaces in the first buffer), and FIG. 6B assumes a case in which M is greater than N (i.e., the number of buffer spaces in the second buffer is greater than the number of buffer spaces in the first buffer).

For example, referring to FIG. 6A, the second buffer 130 of the primary controller 100 sequentially stores data 1 to data N as a second data set. In addition, the primary controller 100 receives, from the MLPE 200, new data 1 to data N as a first data set.

Here, since the first data set does not include data N, which is the latest non-zero data in the second data set (second buffer latest data), the first data set may be regarded as being received after a cycle (TxN) in which the MLPE 200 stores N pieces of data from a point in time at which the second data set is received.

The processor 120 of the primary controller 100 searches, in a reverse order of the storage order of the second buffer 130, whether the latest non-zero data in the second data set is present in the first data set of N pieces of data. Here, conversely, when the latest non-zero data is present in the second data set, the processor 120 searches, in a storage order of the second buffer 130, whether the latest data is present in the first data set, and when data N, which is the latest data in the first data set, is not present, the processor 120 stores new data 1 to data N in the second buffer 130.

Here, new data 1 to data N may be stored by being respectively overwritten on data 1 to data N stored in first to Nth buffer spaces.

FIG. 6B assumes the case in which M is greater than N (i.e., the number of buffer spaces of the second buffer is greater than the number of buffer spaces of the first buffer), as described above. Unlike FIG. 6A, in the embodiment of FIG. 6B, previous cumulative data 1 to cumulative data (M-N) may be previously stored in first to (M-N)th buffer spaces of the second buffer, and cumulative data 1 to cumulative data N may be stored in (M-N+1)th to Mth buffer spaces.

In this case, as in FIG. 6A, when the first data set including new data 1 to data N is obtained, previous cumulative data (N+1) to cumulative data (M-N) may be stored in first to (M-2N)th buffer spaces, cumulative data 1 to cumulative data N may be stored in (M-2N+1)th to (M-N)th buffer spaces, and new cumulative data 1 to new cumulative data N may be respectively stored in (M-N+1)th to Mth buffer spaces.

That is, according to an embodiment, when the second buffer latest data is not present in the first data set, the processor 120 may sequentially store the entire first data set in the (M-N+1)th to Mth buffer spaces of the second buffer.

Accordingly, new data 1 to new data N may be sequentially stored in the first to Nth buffer spaces of the second buffer 130.

The processor 120 of the primary controller 100 searches, in the reverse storage order, whether the latest non-zero data is present in the second data set of N pieces of data stored in the second buffer 130, and when there is no data stored in the second buffer 130 as a result of searching for, that is, when all the second data set stored in the second buffer 130 are zero, the processor stores all the first data set of N pieces of data, received from the MLPE 200, in the second buffer 130.

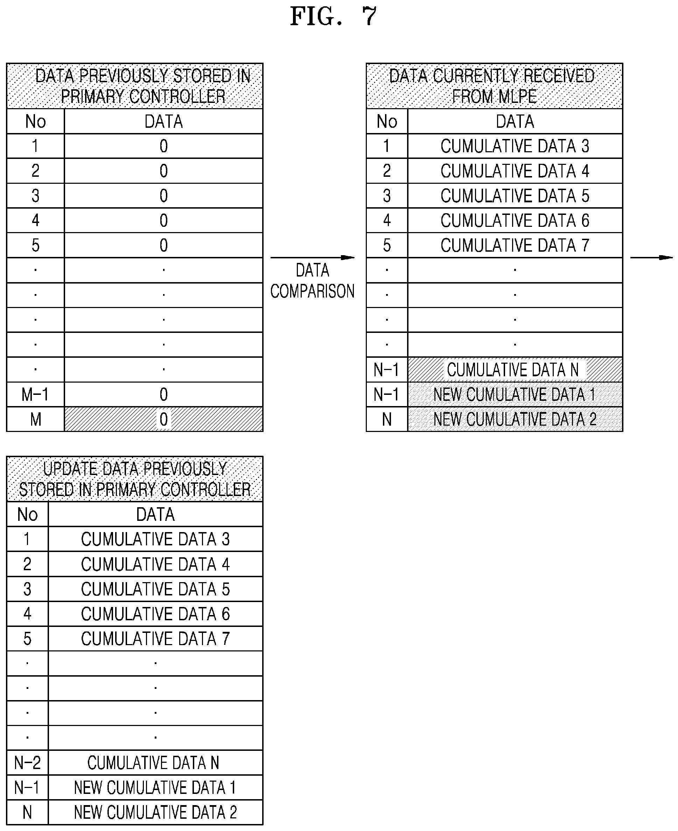

FIG. 7 illustrates examples of updating the second buffer according to another embodiment of the present disclosure.

For example, referring to FIG. 7, the second buffer 130 of the primary controller 100 does not store data in first to Mth buffer spaces. In addition, the primary controller 100 receives, from the MLPE 200, data 3 to data N, new data 1, and new data 2.

Here, since no data is stored in the second buffer 130, it may be regarded as an initial operation state of the MLPE 200.

As described above, since no data is stored in the second buffer 130, the processor 120 sequentially stores data 3 to data N, new data 1, and new data 2, which form a first data set, in first to Nth buffer spaces of the second buffer 130.

That is, according to an embodiment, when the second buffer latest data is not present in a second data set, the processor 120 may sequentially store the entire first data set in (M-N+1)th to Mth buffer spaces of the second buffer.

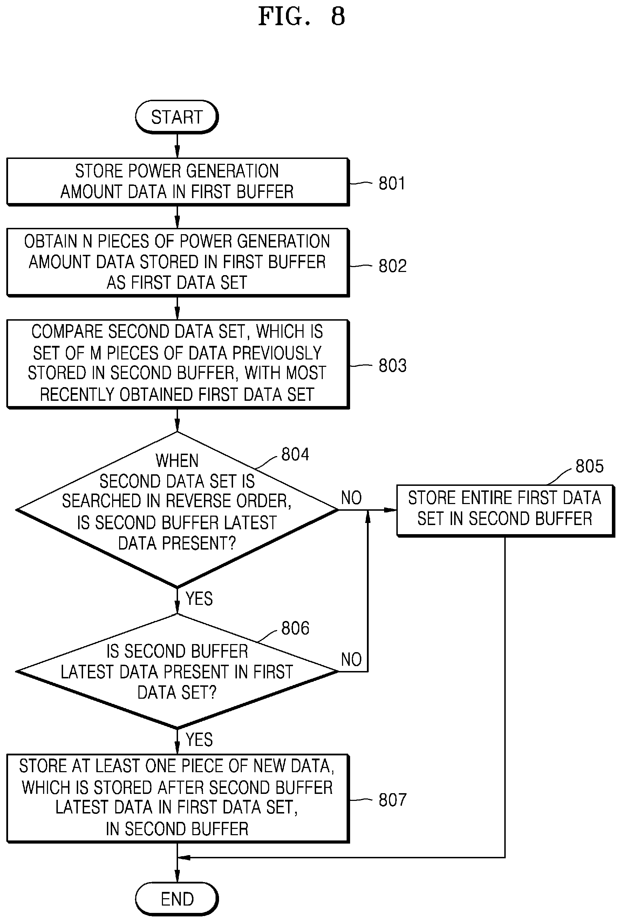

FIG. 8 is a flowchart illustrating a method of updating cumulative power generation amount data of the MLPE according to an embodiment of the present disclosure.

Referring to FIG. 8, the MLPE 200 stores power generation amount data in the first buffer (801).

Next, the primary controller 100 obtains N pieces of power generation amount data stored in the first buffer as a first data set (802).

Next, the primary controller 100 compares a second data set, which includes M pieces of data previously stored in the second buffer, with the most recently obtained first data set (803).

Next, the primary controller 100 determines whether second buffer latest data is present when the second data set is searched in a reverse order (804), and when the second buffer latest data is present, the primary controller 100 stores the entire first data set in the second buffer (805).

Alternatively, when the second buffer latest data is not present, whether the second buffer latest data is included in the first data set is determined (806), and when the second buffer latest data is present, the entire first data set is stored in the second buffer (805).

Further, when the second buffer latest data is not present in the first data set, the processor stores at least one piece of new data, which is stored after the second buffer latest data in the first data set, in the second buffer (807).

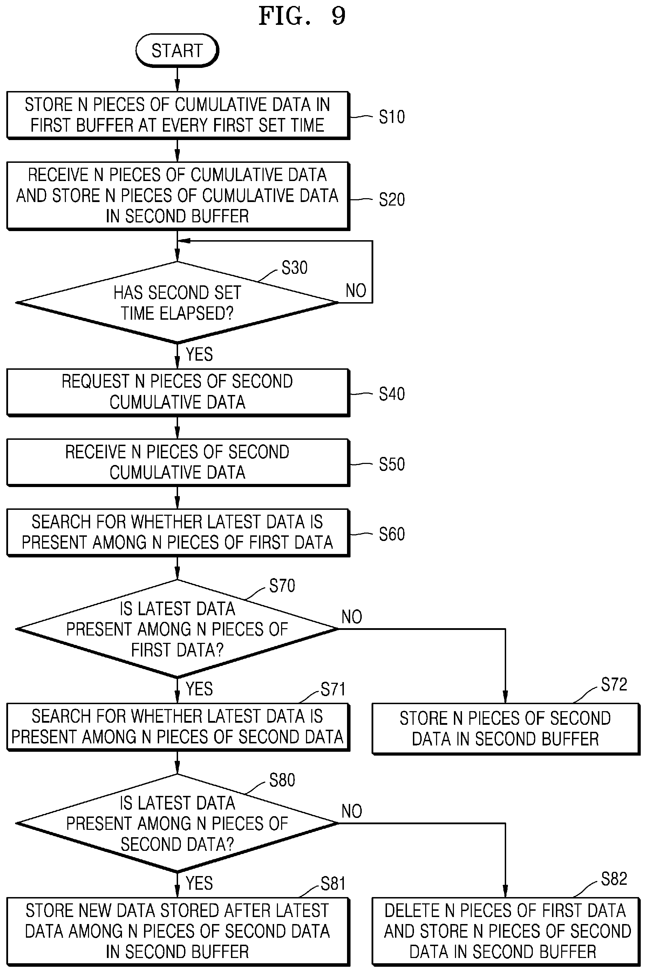

FIG. 9 is a detailed flowchart illustrating a method of updating cumulative power generation amount data of the MLPE according to an embodiment of the present disclosure.

Referring to FIG. 9, in the method of updating the cumulative power generation amount data of the MLPE according to an embodiment of the present disclosure, first, the MLPE 200 sequentially stores N pieces of data, each obtained by accumulating a power generation amount of the photovoltaic panel 10 at every first set time, in the first buffer 230 (S10).

Next, the primary controller 100 requests a second data set of N pieces of data from the MLPE 200, receives the second data set of N pieces of data from the MLPE 200, and stores the second data set of N pieces of data in the second buffer 130 (S20).

Next, whether the second set time has elapsed is determined (S30), and when the second set time has elapsed, the primary controller 100 requests a first data set of N pieces of data from the MLPE 200 (S40) and receives the first data set of N pieces of data from the MLPE 200 (S50).

Next, the primary controller 100 compares the second data set of N pieces of data previously stored in the second buffer 130 with the first data set of N pieces of data currently received from the MLPE 200, and updates the second data set of N pieces of data.

Here, the operation of updating the second data set of N pieces of data includes searching for, in a reverse order of the storage order of the second buffer 130, whether latest non-zero data is present in the second data set of N pieces of data (S60).

When no latest data is present in the second buffer 130, the first data set of N pieces of data is entirely stored in the second buffer 130 based on the absence of the latest data in the second buffer 130 (S72).

Next, when the latest data is present in the second data set of N pieces of data (S70), the first data set is searched in a storage order in the first buffer 230 based on the presence of the latest data in the second buffer 130 (S71).

Next, when the latest data is present in the first data set of N pieces of data (S80), at least one piece of new data, which is stored after the latest data in the first data set of N pieces of data, is stored in the second buffer 130 based on the presence of the latest data in the first buffer 230 (S81).

On the other hand, when the latest data is not present in the first data set of N pieces of data, the second data set of N pieces of data in the second buffer 130 is deleted, and the first data set of N pieces of data is stored in the second buffer 130 (S82).

As described above, in the method of updating the cumulative power generation amount data of the MLPE according to an embodiment of the present disclosure, even when a communication failure occurs between the MLPE 200 and the primary controller 100 and communication is not performed for a certain period of time, data loss may be prevented as long as the communication is performed at least once within the cycle (TxN) in which the MLPE 200 stores N pieces of data from a point in time at which the second data set of N pieces of data is received by the primary controller 100. In addition, duplicate data storage due to a system failure may be prevented. As a result, the reliability of the data may be improved, thereby enabling accurate monitoring of a cumulative power generation amount of the photovoltaic panel 10.

In the detailed description of the present disclosure, specific embodiments have been described, but of course, various modifications are possible without departing from the scope of the present disclosure. Therefore, the scope of the present disclosure should not be limited to the described embodiments, but should be determined not only by the scope of the patent claims described later, but also by the scope of this patent claim and equivalents.

### Explanation Of Reference Numerals Designating The Major Elements Of The Drawings

100: primary controller
200: MLPE
300: server

## Claims

1. A method of operating a photovoltaic power generation system, the method comprising:
generating power generation amount data obtained by accumulating a power generation amount of a photovoltaic panel at every first set time;
sequentially storing the power generation amount data in a first buffer;
obtaining N pieces of the power generation amount data stored in the first buffer as a first data set at every second set time, wherein N is a natural number greater than or equal to 2;
comparing a second data set, which is a set of M pieces of data previously stored in a second buffer, with the first data set that is most recently obtained, wherein M is a natural number greater than or equal to 2; and
in response to the comparing, updating the second buffer based on the first data set.

2. The method of claim 1, wherein the comparing includes:
searching for, in a reverse order of the storage order of the second buffer (hereinafter referred to as a reverse order), whether latest non-zero data (hereinafter referred to as second buffer latest data) is present in the second data set; and
searching for, in a storage order of the first buffer, whether the second buffer latest data is present in the first data set, when the second buffer latest data is present.

3. The method of claim 2, wherein, in the updating, when the second buffer latest data is present in the first data set, at least one piece of new data, which is stored after the second buffer latest data, is stored in the second buffer.

4. The method of claim 3, wherein
in the updating,
when a number of the at least one piece of new data, which is stored after the second buffer latest data, in the first data set is Nnew,
Nnew pieces of the data are sequentially stored in (M-Nnew+1)th to Mth spaces among storage spaces of the second buffer.

5. The method of claim 4, wherein
in the updating,
pieces of data previously stored in first to (M-Nnew)th buffer spaces of the second buffer are deleted, and
pieces of data stored in the (M-Nnew+1)th to Mth buffer spaces are newly stored in first to (M-Nnew)th spaces.

6. The method of claim 2, wherein, in the updating, when the second buffer latest data is not present in the first data set, the first data set is entirely stored in the second buffer.

7. The method of claim 6, wherein, in the updating, the first data set is entirely stored sequentially in (M-N+1)th to Mth buffer spaces of the second buffer.

8. The method of claim 2, wherein, in the updating, when the second buffer latest data is not present in the second data set, the first data set is entirely stored in the second buffer.

9. The method of claim 8, wherein, in the updating, the first data set is entirely stored sequentially in (M-N+1)th to Mth buffer spaces of the second buffer.

10. The method of claim 1, wherein
the first buffer has a size configured to store up to the N pieces of the power generation amount data, and
the second buffer has a size configured to store up to the M pieces of the power generation amount data,
wherein N is a number less than or equal to M.

11. A primary controller of a photovoltaic power generation system, wherein the primary controller is configured to:
request, to a module-level power electronics (MLPE) of the photovoltaic power generation system, for a first data set stored in a first buffer of the MLPE;
obtain the first data set from the MLPE;
compare a second data set, which is a set of M pieces of data (where M is a natural number greater than or equal to 2) previously stored in a second buffer of the primary controller, with the first data set that is most recently received from the MLPE; and
in response to the comparing, update the second buffer based on the first data set.

12. The primary controller of claim 11, wherein
the first data set is a set of N pieces of data (where N is a natural number greater than or equal to 2), each obtained by accumulating a power generation amount of a photovoltaic panel at every first set time, and
the primary controller is further configured to request the first data set from the MLPE at every second set time.

13. The primary controller of claim 11, wherein
the primary controller is further configured to search for, in a reverse order of the storage order (hereinafter referred to as a reverse order) of the second buffer, whether latest non-zero data (hereinafter referred to as second buffer latest data) is present in the second data, search for, in a storage order of the first buffer, whether the second buffer latest data is present in the first data set based on the presence of the second buffer latest data, and store at least one piece of new data, which is stored after the second buffer latest data, in the second buffer based on the presence of the second buffer latest data in the first data set.

14. The primary controller of claim 11, wherein the primary controller is further configured to search for, in a reverse order, whether second buffer latest data is present in the second data set, and based on absence of the latest data in the second buffer, entirely store the first data set in the second buffer.

15. The primary controller of claim 11, wherein the primary controller is further configured to search for, in a reverse order, whether second buffer latest data is present in the second data set, search for, in a storage order of the first buffer, whether the second buffer latest data is present in the first data set based on the presence of the second buffer latest data, and entirely store the first data set of N pieces of data in the second buffer based on absence of the second buffer data in the first data set.

16. The primary controller of claim 11, wherein
the first buffer has a size configured to store up to N pieces of power generation amount data, and
the second buffer has a size configured to store up to M pieces of power generation amount data,
wherein N is a number less than or equal to M.

17. The primary controller of claim 11, wherein the MLPE is configured to sequentially delete the power generation amount data, in a storage order of the first buffer, after the N pieces of power generation amount data are stored in the first buffer, and sequentially store new data.

18. The primary controller of claim 11, wherein the primary controller is further configured to, after the second data set including M pieces of power generation amount data is stored in the second buffer, sequentially delete the power generation amount data in a storage order of the second buffer, and sequentially store new data.

19. An inverter including a primary controller of a photovoltaic power generation system, wherein the inverter is configured to:
request, to a module-level power electronics (MLPE) of the photovoltaic power generation system, for a first data set stored in a first buffer of the MLPE;
obtain the first data set from the MLPE;
compare a second data set, which is a set of M pieces of data (where M is a natural number greater than or equal to 2) previously stored in a second buffer of the primary controller, with the first data set that is most recently received from the MLPE; and
in response to the comparing, update the second buffer based on the first data set.

20. The inverter of claim 19, wherein
the first data set is a set of N pieces of data (where N is a natural number greater than or equal to 2), each obtained by accumulating a power generation amount of a photovoltaic panel at every first set time, and
the primary controller is configured to request the first data set from the MLPE at every second set time.
